# EUROPÄISCHE PATENTSCHRIFT

(11) **EP 0 465 692 B1**
(45) Veröffentlichungstag und Bekanntmachung des Hinweises auf die Patenterteilung: **08.06.1994**
(21) Anmeldenummer: 90113079.9
(22) Anmeldetag: 09.07.1990
(51) Int. Cl.: H05K 7/14

(54) **Schaltungsträger**
Circuit support
Support de circuit

(43) Veröffentlichungstag der Anmeldung: 15.01.1992
(73) Patentinhaber: SIEMENS AKTIENGESELLSCHAFT, 80333 München (DE)
(72) Erfinder: Kasowski, Hermann, Dipl.-Ing.(FH), D-8450 Amberg (DE); Schönberger, Eduard, Dipl.-Ing.(FH), D-8450 Amberg (DE); Schmidt, Heinz, Dipl.-Ing.(FH), D-8457 Kümmersbruck (DE)

(56) Entgegenhaltungen:
- DE-A- 3 222 178
- DE-A- 3 732 249
- DE-B- 1 045 500
- US-A- 2 904 768
- US-A- 4 509 647

## Beschreibung

Die Erfindung betrifft einen Schaltungsträger, der Bestandteil eines Geräts mit einem Gehäuse ist, dessen Rückwand aus Kunststoff besteht, wobei der Schaltungsträger eine stromleitende Verbindung zwischen mindestens zwei Leiterplatten im Gehäuse herstellt, wobei die Rückwand des Gehäuses als Schaltungsträger ausgebildet ist.

Aus der US-PS 4 509 647 ist ein Schaltungsträger gemäß dem Oberbegriff des Anspruchs 1 bekannt. Die Rückwand bzw. der Schaltungsträger dieses Standes der Technik ist dabei eine konventionelle Leiterplatte aus Epoxydharz. Derartige Leiterplatten sind üblicherweise auf ihrer Oberfläche mit einem Schutzlack beschichtet, der nur an den Kontaktstellen entfernt ist. Ferner sind bei der Rückwand der US-PS 4 509 647 Metallstifte in die Leiterplatte eingesetzt, welche als Kontaktstifte zwischen den Leiterbahnen der Leiterplatte und in das Gehäuse einzuschiebenden Steckkarten dienen.

Schaltungsträger der obengenannten Art sind auch bei Automatisierungsgeräten, z.B. der Type S5-105 R, die im Siemens-Katalog SIMATIC S5 Automatisierungsgeräte S5-101 R und 55-105 R, Katalog ST 50 1984, dargestellt ist, bekannt. Das vorgenannte Automatisierungsgerät besteht aus einem Gehäuse mit einer rückwärtig angeordneten Bus-Querleiterplatte aus Kunststoff, die Leiterbahnen trägt und zur Innenseite hin Federleisten aufweist. Baugruppen mit Leiterplatten können von der Frontseite her in das Gerätegehäuse eingeschoben werden.

Über an der Rückseite der Leiterplatten angebrachte Kontaktmesserleisten, die in die Federleisten steckbar sind und über die Bus-Querleiterplatte kann ein Daten-und Signalaustausch zwischen verschiedenen gesteckten Baugruppen erfolgen.

Weiterhin ist der Druckschrift DE-OS 32 22 178 ein elektrisch isolierender Träger zu entnehmen, auf welchem im Heißprägeverfahren metallische Leiter aufgebracht sind. Hier werden gleichzeitig mit dem aus thermoplastischem Material bestehenden Trägerbauteil Bauelementeaufnahmen und Verbindungselemente hergestellt.

Eine weitere Druckschrift DE-OS 37 32 249 befaßt sich mit Verfahren zur Herstellung von dreidimensionalen Leiterplatten. Das hier beschriebene Verfahren erlaubt, Leiterbahnen auch in der dritten Dimension zu erzeugen.

Ausgehend von Schaltungsträgern der obengenannten Art besteht bei der vorliegenden Erfindung die Aufgabe, einen einstückigen Schaltungsträger als integralen Bestandteil des Gerätegehäuses zu schaffen, der nicht nur die Funktion einer stromleitenden Verbindung zwischen den genannten Leiterplatten herstellt, sondern auch mechanische Funktionen übernehmen kann. Hierzu gehört das Zuordnen von Leiterplatten und die Aufnahme und Verteilung von Kräften. Außerdem ist über den Schaltungsträger die Gerätebefestigung möglich.

Die Aufgabe wird dadurch gelöst, daß die Rückwand des Gehäuses einstückig ausgebildet ist, daß sie an ihrer Oberfläche metallisierte, stromleitende Bahnen und Flächen aufweist, daß auf der Innenseite der Rückwand hervorragende Anschlußmittel angespritzt sind, die selbst metallisiert sind und durch die Bahnen und/oder die Flächen stromleitend miteinander verbunden sind, so daß die Leiterplatten durch Steckverbindung an die angespritzten Anschlußmittel elektrisch anschließbar und am Schaltungsträger befestigbar sind.

Eine vorteilhafte Ausführungsform ist gegeben, wenn die Anschlußmittel als metallisierte erste Stifte ausgeführt sind und zur Steckverbindung mit den ersten Stiften Federleisten vorgesehen sind, die elektrisch und mechanisch jeweils mit den Leiterplatten verbunden sind. Durch den Abstand zwischen den ersten Stiften, die schon beim Fertigungsprozeß angeformt werden, wird nämlich auf einfache Weise eine gute Isolierung erreicht.

Eine weitere bequeme Möglichkeit zum Anschluß der Leiterplatten besteht, wenn die Anschlußmittel als benachbarte, metallisierte zweite Stifte in federähnlicher Gestalt ausgebildet sind, zwischen die die Leiterplatte zur Kontaktierung mit ihren Anschlußflächen steckbar ist.

Eine zusätzliche Vereinfachung des Geräteaufbaus wird erreicht, indem ein Teil der metallisierten Bahnen und Flächen zum Zwecke der elektromagnetischen Schirmung an ein Null- und/oder Schirmpotential angebunden sind.

Ist die Rückwand als Befestigungsteil ausgebildet und ist an ihrer Außenseite eine metallisierte Andruckfläche vorgesehen, die bei rückwärtiger Befestigung des Befestigungsteils mit einer Masseschiene kontaktierbar ist, so stellt dies eine besonders einfache Ausführungsform zur Anbindung an die Masse dar.

Zur Verbesserung der Kühlung von Geräten mit derartigen Schaltungsträgern, durch die Leiterplatten elektrisch miteinander verbunden sind, erweist es sich als zweckmäßig, wenn an der Rückwand Kühlrippen angespritzt sind, die metallisiert sind. Hierdurch ergibt sich eine vergrößerte wärmeleitende Fläche, über die die beim Betrieb der Leiterplatten oder elektronischen Bauelemente erzeugte Verlustwärme in verstärktem Maße an die Außenluft abgeführt werden kann.

In der Zeichnung ist ein Ausführungsbeispiel der Erfindung dargestellt, das im folgenden näher beschrieben ist. Es zeigen:
- FIG 1: einen als Rückwand eines Gehäuses dienenden Schaltungsträger in perspektischer Ansicht,
- FIG 2: eine besondere Ausbildung von Anschlußmitteln an dem Schaltungsträger zum Einstecken einer Leiterplatte,
- FIG 3: ein Schnittbild des Schaltungsträgers nach FIG 1 mit Darstellung einer Masseanbindung.

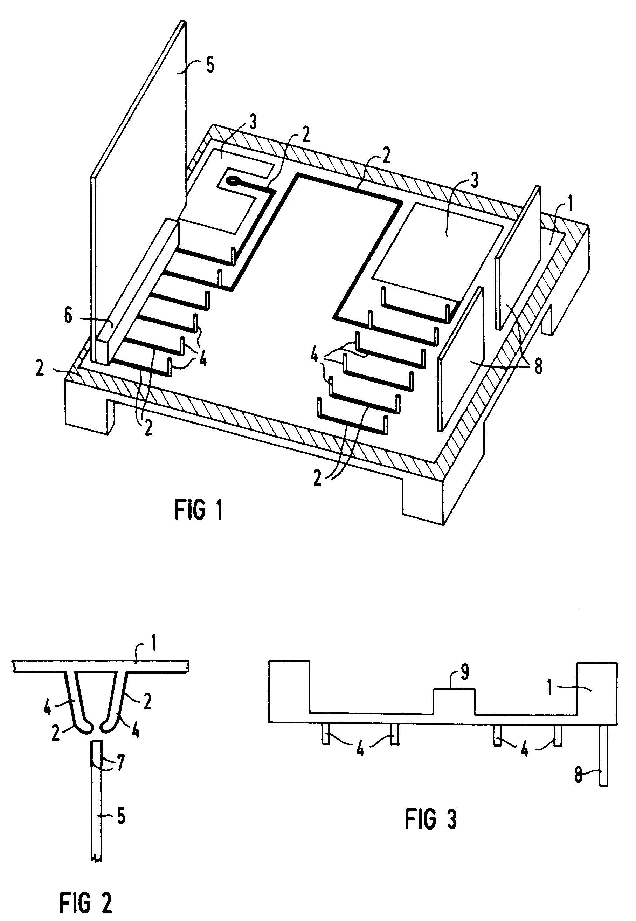

In FIG 1 ist ein Schaltungsträger 1 dargestellt, der neben seiner elektrischen Funktion vermittels von Leitungsverbindungen auch mechanische Funktionen erfüllt, d.h. in dem hier angeführten Beispiel als Rückwand und gleichzeitiges Befestigungsteil eines Gerätegehäuses dienen kann. Hierzu weist der Schaltungsträger 1 Anschlußmittel in Form von Stiften 4 auf, die bereits beim Herstellungsprozeß des Schaltungsträgers 1 angeformt werden. Der Schaltungsträger 1 weist metallisierte Flächen 3 und Bahnen 2 auf, die z.T. eine elektrische Verbindung zwischen den ebenfalls metallisierten Stiften 4 schafft. Auf die metallisierten Stifte sind Federleisten 6 aufsteckbar, die mechanisch und elektrisch mit Leiterplatten 5 verbunden sind. Beispielhaft ist hier nur eine Leiterplatte dargestellt. Somit ist über die Stifte 4 und die Bahnen 2 ein elektrischer Signalaustausch zwischen verschiedenen Leiterplatten 5 möglich. Über die größer angelegten metallisierten Flächen 3 mit höherer Stromtragfähigkeit ist z.B. die Stromversorgung der Leiterplatten 5 möglich. Über eine am äußeren Rand des Schaltungsträgers 1 umlaufende Bahn 2, die elektrisch mit den vollflächig metallisierten Außenseiten verbunden ist, kann beispielsweise eine Schirmung der Schaltung erfolgen. In FIG 1 sind außerdem Kühlrippen 8 dargestellt, die ebenfalls metallisiert sind und über die somit eine verbesserte Abführung der z.B. beim Betrieb der Leiterplatten 5 oder elektronischen Bauelemente erzeugten Verlustwärme erreicht wird.

In FIG 2 ist ein Ausschnitt eines Schaltungsträgers 1 mit besonderen als Anschlußmittel dienenden federähnlichen Stiften 4 dargestellt, die metallisiert sind und mit Bahnen 2 elektrisch in Verbindung stehen. Die besondere Anordnung und Form der Stifte 4 erlaubt es, Leiterplatten 5 durch einfaches Einstecken über ihre elektrischen Anschlußflächen 7 mit den Stiften 4 zu kontaktieren.

FIG 3 zeigt den als Rückwand dienenden Schaltungsträger 1 mit einer Andruckfläche 9, die metallisiert ist und mit dem Null- und Schirmpotential durch Andruck gegen eine rückwärtig befestigte Masseschiene beim Befestigen der Rückwand kontaktiert wird.

Selbstverständlich kann auch jede andere Gehäusewand, d.h. nicht nur die Rückwand, als Schaltungsträger ausgebildet sein. Zudem lassen sich über entsprechende Anschlußmittel nicht nur Leiterplatten 5, sondern beliebige andere elektrische Bauelemente mechanisch und elektrisch verbinden. Der vorangehend beschriebene Schaltungsträger zeichnet sich durch einen geringen Material- und Montageaufwand aus und bringt damit entsprechende Kosteneinsparungen mit sich.

## Patentansprüche

1. Schaltungsträger, der Bestandteil eines Geräts mit einem Gehäuse ist, dessen Rückwand aus Kunststoff besteht, wobei der Schaltungsträger (1) eine stromleitende Verbindung zwischen mindestens zwei Leiterplatten (5) im Gehäuse herstellt, wobei die Rückwand (1) des Gehäuses als Schaltungsträger ausgebildet ist, **dadurch gekennzeichnet,** daß die Rückwand (1) einstückig ausgebildet ist, daß sie an ihrer Oberfläche metallisierte , stromleitende Bahnen (2) und Flächen (3) aufweist, daß auf der Innenseite der Rückwand (1) hervorragende Anschlußmittel (4) angespritzt sind, die selbst metallisiert sind und durch die Bahnen (2) und/oder die Flächen (3) stromleitend miteinander verbunden sind, so daß die Leiterplatten (5) durch Steckverbindung an die angespritzten Anschlußmittel (4) elektrisch anschließbar und am Schaltungsträger (1) befestigbar sind.

2. Schaltungsträger nach Anspruch 1, **dadurch gekennzeichnet,** daß die Anschlußmittel als metallisierte erste Stifte (4) ausgeführt sind und zur Steckverbindung mit den ersten Stiften Federleisten (6) vorgesehen sind, die elektrisch und mechanisch jeweils mit den Leiterplatten (5) verbunden sind.

3. Schaltungsträger nach Anspruch 1, **dadurch gekennzeichnet,** daß die Anschlußmittel als benachbarte, metallisierte zweite Stifte (4) in federähnlicher Gestalt ausgebildet sind, zwischen die die Leiterplatte (5) zur Kontaktierung mit ihren Anschlußflächen (7) steckbar ist.

4. Schaltungsträger nach einem der vorangehenden Ansprüche, **dadurch gekennzeichnet,** daß ein Teil der metallisierten Bahnen (2) und Flächen (3) zum Zwecke der elektromagnetischen Schirmung an ein Null- und/oder Schirmpotential angebunden sind.

5. Schaltungsträger nach einem der vorangehenden Ansprüche, **dadurch gekennzeichnet,** daß an der Rückwand (1) Kühlrippen (8) angespritzt sind, die metallisiert sind.

6. Schaltungsträger nach einem der vorangehenden Ansprüche, **dadurch gekennzeichnet,** daß die Rückwand als Befestigungsteil (1) ausgebildet ist und an ihrer Außenseite eine metallisierte Andruckfläche (9) vorgesehen ist, die bei rückwärtiger Befestigung des Befestigungsteils mit einer Masseschiene kontaktierbar ist.

## Claims

1. Circuit mount which is a component of an apparatus with a housing, the rear wall of which is made of plastics, wherein the circuit mount (1) produces an electrically conductive connection in the housing between at least two printed circuit boards (5), the rear wall (1) of the housing being formed as a circuit mount, characterised in that the rear wall (1) is formed in one piece, in that on its surface it has metallized electrically conductive tracks (2) and surfaces (3), in that injection-moulded onto the inner side of the rear wall (1) there are projecting connecting means (4), which are themselves metallized and connected in an electrically conductive manner to one another by the tracks (2) and/or the surfaces (3), so that the printed circuit boards (5) are able to be connected electrically to the injection-moulded connecting means (4) by a plug-in connection and are able to be attached to the circuit mount (1).

2. Circuit mount according to claim 1, characterised in that the connecting means are constructed as metallized first pins (4) and, for a plug-in connection with the first pins, there are provided female multi-point connectors (6), which are connected electrically and mechanically in each case to the printed circuit boards (5).

3. Circuit mount according to claim 1, characterised in that the connecting means are formed as adjacent metallized second pins (4) in a spring-like form, between which the printed circuit board (5) is able to be inserted for contact with its connecting surfaces (7).

4. Circuit mount according to one of the preceding claims, characterised in that a portion of the metallized tracks (2) and surfaces (3) are connected to zero potential and/or shield potential for the purpose of electromagnetic shielding.

5. Circuit mount according to one of the preceding claims, characterised in that cooling fins (8), which are metallized, are injection-moulded onto the rear wall (1).

6. Circuit mount according to one of the preceding claims, characterised in that the rear wall is formed as a mounting part (1) and provided on its outside there is a metallized contact surface (9), which is able to be contacted with a grounding bar during rearward attachment of the mounting part.

## Revendications

1. Support pour circuits, qui fait partie d'un appareil comportant un boîtier, dont la face arrière est réalisée en matière plastique, le support (1) pour circuits établissant une liaison conductrice entre au moins deux plaquettes à circuits imprimés (5), et la paroi arrière (1) du boîtier étant agencée sous la forme d'un support pour circuits, caractérisé par le fait que la paroi arrière (1) est réalisée d'un seul tenant, qu'elle possède, au niveau de sa surface, des voies conductrices métallisées (2) et des surfaces conductrices métallisées (3), que sur la face intérieure de la paroi arrière (1) sont moulés par injection des moyens saillants de raccordement (4), qui sont eux-mêmes métallisés et sont connectés entre eux de façon conductrice par les voies (2) et/ou par les surfaces (3), de sorte que les plaquettes à circuits imprimés (5) peuvent être raccordées électriquement au moyen d'une liaison à enfichage aux moyens de raccordement (4) moulés par injection et peuvent être fixées sur le support (1) pour circuits.

2. Support pour circuits suivant la revendication 1, caractérisé par le fait que les moyens de raccordement sont réalisés sous la forme de premières broches métallisées (4) et que pour la liaison par enfichage avec les premières broches, il est prévu des barrettes à ressorts (6), qui sont reliées électriquement et mécaniquement respectivement aux plaquettes à circuits imprimés (5).

3. Support pour circuits suivant la revendication 1, caractérisé par le fait que les moyens de raccordement sont réalisés sous la forme de secondes broches voisines métallisées (4) ayant une forme analogue à celle de ressorts et entre lesquelles la plaquette à circuits imprimés (5) peut être enfichée de manière à établir un contact par ses surfaces de raccordement (7).

4. Support pour circuits suivant l'une des revendications précédentes, caractérisé par le fait qu'une partie des voies métallisées (2) et des surfaces métallisées (3) sont placées à un potentiel nul et/ou à un potentiel de protection, pour réaliser le blindage électromagnétique de protection.

5. Support pour circuits suivant l'une des revendications précédentes, caractérisé par le fait que sur la paroi arrière (1) sont formées par moulage par injection des ailettes de refroidissement (8) qui sont métallisées.

6. Support pour circuits suivant l'une des revendications précédentes, caractérisé par le fait que la paroi arrière est réalisée sous la forme d'une partie de fixation (1) et que sur sa face extérieure est prévue une surface de serrage métallisée (9), avec laquelle peut être mis en contact un rail de masse lors de la fixation de la pièce de fixation sur la paroi arrière.
